# DEMANDE DE BREVET EUROPEEN

(11) **EP 2 259 079 A1**
(43) Date de publication de la demande: **08.12.2010**
(21) Numéro de dépôt: 09161305.9
(22) Date de dépôt: 27.05.2009
(51) Int. Cl.: G01R 31/36

(54) **Système de mesure de tension des cellules d'une pile à combustible**

(71) Demandeur: Belenos Clean Power Holding AG, 2502 Bienne (CH)
(72) Inventeur: Toth, Antoine, 2800, Delémont (CH)
(74) Mandataire: Ravenel, Thierry Gérard Louis

(57) **Abrégé**

La présente invention concerne un système de contrôle d'une pile de blocs (3) électrochimiques ayant chacune deux points de connexion. Ce système comprend un circuit de commande (11) prévu pour envoyer un signal de sélection permettant de sélectionner au moins un bloc électrochimique pour une mesure de différence de potentiel. Le système comprend en outre des modules de contrôle (12) agencés pour être respectivement couplés à des groupes (13) distinctes de blocs (3) de la pile et ayant chacun sa propre tension de référence. Chaque module de contrôle est agencé pour, en réponse au signal de sélection envoyé par le circuit de commande, réaliser une mesure de différence de potentiel d'un bloc électrochimique sélectionnée et appartenant au groupe de blocs électrochimique auquel le module de contrôle est associé. Le système se **caractérise en ce que** chaque module de contrôle comprend une pluralité d'amplificateurs différentielles (26) prévus pour être connectés chacun par deux entrées aux deux bornes d'un bloc électrochimique afin de fournir en sortie une tension représentative de la différence de potentiel présente entre les bornes dudit bloc électrochimique.

## Description

La présente invention concerne un système de contrôle d'une pile de blocs électrochimiques ayant chacune deux points de connexion. Ce système comprend un circuit de commande prévu pour envoyer un signal de sélection permettant de sélectionner au moins un bloc électrochimique pour une mesure de différence de potentiel. Ce système comprend en outre des modules de contrôle agencés pour être respectivement couplés à des séries distinctes de blocs de la pile et ayant chacun sa propre tension de référence. Chaque module de contrôle est agencé pour, en réponse au signal de sélection envoyé par le circuit de commande, réaliser une mesure de différence de potentiel d'un bloc électrochimique sélectionnée et appartenant au groupe de blocs électrochimique auquel le module de contrôle est associé.

### ARRIERE PLAN TECHNOLOGIQUE

Une cellule à combustible est un dispositif électrochimique prévu pour convertir une énergie chimique directement en énergie électrique. Par exemple, un type de pile à combustible inclus une anode et une cathode entre lesquelles est arrangée une membrane à échange de proton souvent appelée membrane électrolyte polymère. Ce type de membrane permet de ne laisser passer que les protons entre l'anode et la cathode de la cellule à combustible. Au niveau de l'anode, de l'hydrogène diatomique subit une réaction afin de produire des ions H⁺ qui vont passer à travers la membrane électrolyte polymère. Les électrons produits par cette réaction rejoignent la cathode par un circuit externe à la cellule à combustible, produisant ainsi un courant électrique.

Du fait qu'une seule cellule à combustible ne produit, en général, qu'une faible tension (environ 1 Volt), on assemble souvent les cellules à combustibles de manière à constituer des piles formées d'une multitude de cellules à combustible montées en série de manière à permettre de produire une tension plus élevée qui est l'addition des tensions de chaque cellule.

L'expérience à montré qu'il était important de pouvoir contrôler l'état des différentes cellules d'une pile à combustible durant le fonctionnement de celle-ci. Une manière de s'assurer du bon fonctionnement d'une pile à combustible est de contrôler les différences de potentiel entre les deux points de connexion de chaque cellule de la pile (autrement dit, contrôler les tensions respectives des différentes cellules). Selon la puissance raccordée, d'une part, et le plus ou moins bon état d'une cellule, d'autre part, la tension de la cellule peut fluctuer entre 0 et 1,2 volts environ. Ainsi, dans le cas d'une pile formée de plusieurs dizaines de cellules en série, la différence de potentiel entre les points de connexion de certaines cellules et la masse peut s'élever à plusieurs dizaines, voir même centaines, de volts. Malheureusement, les dispositifs à semi-conducteurs utilisés normalement pour la mesure de basses tensions ne supportent pas des tensions élevées (supérieures à 12, voire 18 volts) entre leurs entrées et la masse.

Le document de brevet WO 2006/058394 décrit un système de mesure de tensions de cellules qui évite le problème ci-dessus. Le système décrit dans ce document antérieur comprend plusieurs unités de mesure de tensions associées chacune à un groupe de cellules contiguës de la pile à combustible. Les différentes unités de mesure de tension sont découplées galvaniquement les unes des autres. La masse de chaque unité de mesure est reliée à un point de connexion correspondant à l'extrémité négative du groupe de cellules contiguës auquel elle est associée, de manière à ce que la tension de ce point de connexion serve de tension de référence pour l'unité de mesure. Grâce à l'utilisation d'unités de mesure de tension distinctes, chargées chacune de contrôler un groupe comprenant un nombre limité de cellules, il est possible de limiter la tension en mode commun à laquelle sont soumis les dispositifs semi-conducteurs servant à la mesure de la tension à des valeurs acceptables Bien que découplées galvaniquement les unes des autres, les différentes unités de mesures sont reliées à un bus d'alimentation commun par couplage capacitif ou inductif. De plus, les unités de mesure sont encore prévues pour fournir des valeurs numériques représentatives des tensions mesurées à un bus de données commun par l'intermédiaire d'un opto-coupleur.

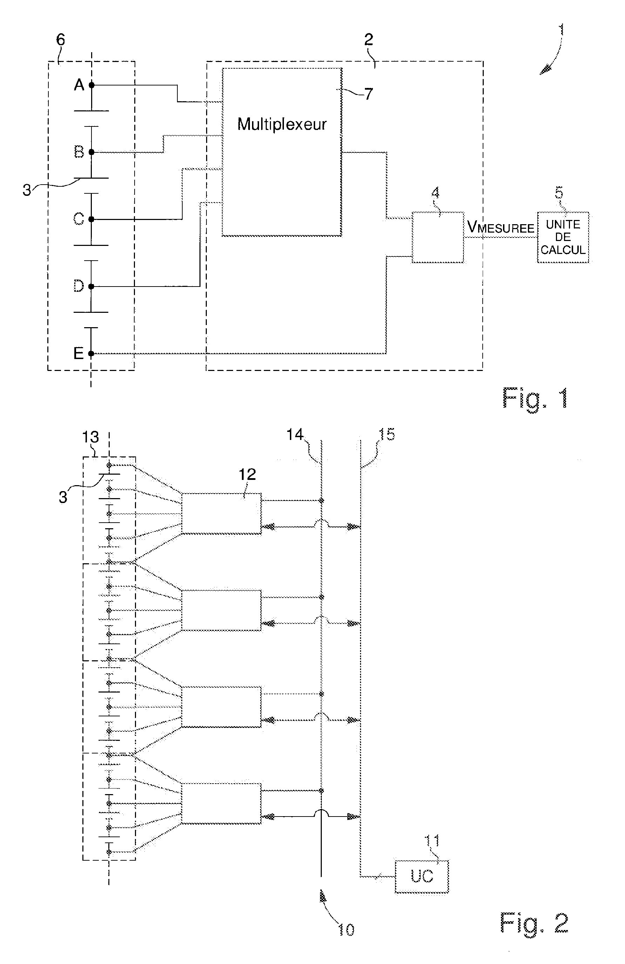

La figure 1 illustre de manière schématique le principe de fonctionnement d'une unité de mesure de tension 1 du type décrit dans le document antérieur susmentionné. On voit sur la figure 1 un groupe de cellules 6 formé de plusieurs cellules contiguës 3. Le groupe 6 de cellules est relié à une unité de mesure de tension 1 chargée de mesurer la différence de potentiel des cellules. Dans l'exemple visible à la figure 1, on peut voir un groupe 6 de quatre cellules contiguës 3 reliées à l'unité de mesure 1 par cinq point de connexion A, B, C, D et E. Le point de connexion E donne sa tension de référence à l'unité de mesure 1. Les points de connexion A, B, C et D sont reliés à un multiplexeur 7 dont la sortie est reliée à une première entrée d'un convertisseur analogique numérique 4. Le point de connexion E est quant à lui relié à une seconde entrée du convertisseur analogique numérique 4, et ce dernier est prévu pour fournir en sortie un signal numérique représentatif de la tension entre ces deux entrées.

Les tensions que l'unité de mesure 1 est prévue pour contrôler sont les tensions tension U_{AB}, U_{BC}, U_{CD} et U_{DE}. On a vu que la mesure de la différence de potentiel se fait par rapport au potentiel du point de connexion E. De ce fait, la mesure de la différence de potentiel entre les points de connexion de chaque cellule 3 se fait par soustraction entre les différences de potentiel. En effet, les tensions mesurées sont les tensions U_{AE}, U_{BE}, U_{CE} et U_{DE}. Pour avoir les tensions U_{AB}, U_{BC}, U_{CD}, il est nécessaire pour l'unité de mesure de réaliser des calculs. En pratique, la tension U_{AB} est calculée par soustraction de U_{AE} par U_{BE}.

Selon le document WO 2006/058394 susmentionné, ce sont les valeurs des tensions U_{AE}, U_{BE}, U_{CE} et U_{DE} qui sont envoyées sur le bus de données. Ces valeurs sont ensuite reçues par une unité centrale de traitement (non représentée) qui est commune à tout le système. C'est l'unité centrale qui effectue les soustractions décrites plus haut.

Précisons que les tensions envoyées vers l'unité centrale sont numérisées sur 12 bits, un des bit étant un bit de parité servant à repérer d'éventuelles erreurs.

Un inconvénient de cette méthode est lié au calcul qui doit être fait pour connaitre la tension de chaque cellule. En effet, ces calculs imposent une programmation spécifique. De plus, la soustraction de données numériques sur 12 bits avec un bit de parité provoque une perte de précision.

De plus, le système de mesure selon l'art antérieur ne permet pas une grande rapidité de mesure et cela en grande partie à cause de son architecture. En effet, les diverses opérations à effectuer telles l'extraction de chaque différence de potentiel puis la numérisation de ces valeurs pour enfin calculer la différence de potentiel de chaque cellule, ne permettant pas une optimisation du temps de mesure. La fréquence des mesures est alors faible ne permettant pas de surveiller la différence de potentiel des cellules de façon optimale.

### RESUME DE L'INVENTION

L'invention concerne un système de contrôle d'une pile de blocs électrochimiques qui pallie les inconvénients de l'art antérieur à savoir d'avoir un système de contrôle d'une pile de blocs électrochimiques qui est plus simple, plus précis et dont la mesure des différences de potentiels des blocs est réalisée plus rapidement.

A cet effet, l'invention concerne un système utilisant l'empilement de blocs électrochimiques cité ci-avant dont chaque module de contrôle comprend une pluralité d'amplificateurs différentiels prévus pour être connectés chacun par deux entrées aux deux bornes d'un bloc électrochimique afin de fournir en sortie une tension représentative de la différence de potentiel présente entre les bornes dudit bloc électrochimique.

L'avantage de la présente invention est de permettre une mesure directe de la différence de potentiel de chaque bloc. En effet, chaque bloc comprend son propre amplificateur différentiel. Ainsi, la différence de potentiel de chaque bloc est extraire individuellement avant d'être envoyée vers une unité de calcul. Cette mesure directe permet alors de ne pas faire de calcul sur les différences de potentiel allégeant la programmation de l'unité de calcul.

De plus, ce système permet de ne pas avoir de trop forte tension en entrée des amplificateurs différentielles du fait de la division des blocs en module et par le fait que chaque module de contrôle possède sa propre tension de référence. Cette tension de référence propre à chaque module de contrôle permet l'utilisation de composant à faible tension pour des empilements de blocs à tension élevée.

Cela entraîne une plus grande rapidité dans l'extraction de la mesure de différence de potentiel permettant en conséquence une fréquence de mesure plus élevée.

Des modes de réalisation avantageux du système de contrôle d'une pile de blocs électrochimiques font l'objet des revendications dépendantes 2à12.

Un des avantages de ces modes de réalisation est qu'ils permettent une autonomie de chaque module de contrôle. En effet, chaque module de contrôle comprend sa propre alimentation indépendante. Cette auto-alimentation des modules de contrôle permet alors à ces derniers de fonctionner même lorsque la pile à combustible est éteinte.

### BREVE DESCRIPTION DES FIGURES

Les buts, avantages et caractéristiques du système de contrôle d'une pile de blocs électrochimiques apparaitront plus clairement dans la description détaillée suivante d'au moins une forme de réalisation de l'invention donnée uniquement à titre d'exemple non limitatif et illustrée par les dessins annexés sur lesquels :
- la figure 1 représente de manière schématique le système de mesure de tension de cellule selon l'art antérieur
- la figure 2 représente de manière schématique le système de pile à combustible selon la présente invention ; et
- la figure 3 représente de manière schématique le système de mesure selon la présente invention.
- la figure 4 représente de manière schématique un circuit de dérivation de cellule de pile à combustible selon la présente invention.

### DESCRIPTION DETAILLEE

Dans la description suivante, toutes les parties d'une pile à combustible connues d'un homme du métier dans ce domaine technique ne seront expliquées que de manière simplifiée.

Sur la figure 2, on a représenté de manière schématique un système de dérivation 10 conforme à la présente invention associé à une pile à combustible. Cette dernière comprend une multitude de blocs électrochimiques 3 possédant chacun un pôle négatif et un pôle positif servant de points de connexion. Dans le présent exemple, chaque bloc 3 peut être constitué d'une seule cellule à combustible ou de plusieurs cellules à combustible contiguës. Toutefois, pour simplifier, dans la suite de la description on parlera indifféremment de bloc ou de cellule même s'il est possible qu'un bloc soit en fait formé de deux cellules ou plus. Les blocs 3 sont reliés en série pour former ce qu'on appelle communément une pile à combustible. Chaque cellule fournit une tension dont la valeur atteint environ 1.2 Volt ce qui, pour un exemple d'une quarantaine de cellules montées en série, donne une tension totale d'environ 48 Volts.

Les blocs 3 sont regroupés pour former des groupes ou séries 13 de plusieurs blocs. Chaque groupe 13 comprend de préférence le même nombre de blocs 3, et dans le présent exemple chaque groupe comporte quatre blocs. Chaque groupe 13 de blocs 3 est couplé à un module 12. Chaque module 12 est prévu pour communiquer avec une unité de commande centrale 11 gérant l'ensemble des modules via un bus de communication 15. Chaque module 12 est alimenté via un bus d'alimentation 14. Ce bus d'alimentation 14 consiste en un circuit d'alimentation distinct qui n'est pas dépendant de la tension fournie par la pile à combustible. Cela permet aux modules 12 de toujours fonctionner même si la pile à combustible est éteinte.

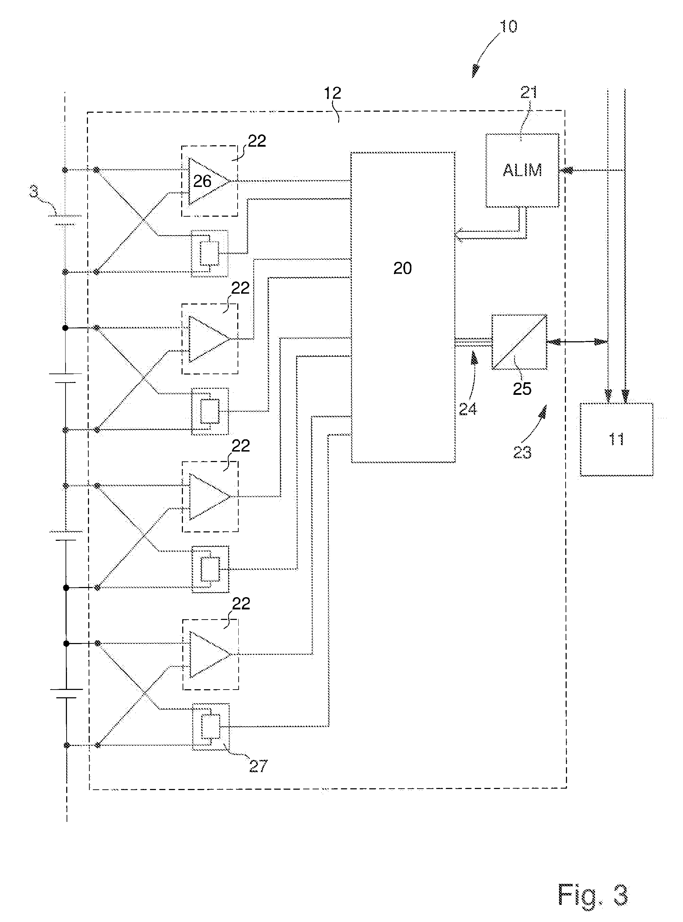

La figure 3 est un schéma plus détaillé d'un module 12 faisant partie d'un système de dérivation selon un mode de réalisation particulier de la présente invention. Chaque module de contrôle 12 comprend une alimentation électrique propre 21 qui reçoit sont énergie du bus d'alimentation 15 tout en en étant séparée galvaniquement. Grâce à cette caractéristique, chaque module 12 peut avoir sa propre tension de référence. Dans le présent exemple, l'isolation galvanique est assurée par un transformateur d'isolation dont le primaire est relié au bus d'alimentation et dont le secondaire fait partie de l'alimentation 21. Dans le présent exemple, l'alimentation 21 fournit aux éléments du module 12 une tension positive +2.5V et une tension négative -2.5V relativement à la tension de référence du module. L'homme du métier comprendra qu'au lieu d'être couplée inductivement au bus d'alimentation 15, l'alimentation 21 pourrait alternativement être couplée capacitivement à ce bus d'alimentation.

Chaque module 12 comprend également une unité de calcul 20 qui dans le présent exemple est implémentée sous la forme d'un microprocesseur. Cette unité de calcul 20 gère ledit module 12 tout en étant elle-même asservie à l'unité de commande centrale 11. L'unité de calcul 20 est alimentée par ladite alimentation du module 12. Elle communique avec l'unité de commande centrale 11 via un système de communication 23. Ce système de communication 23 permet à l'unité de commande centrale 11 d'envoyer des instructions à l'unité de calcul 20 de chaque module 12. Il permet également à chaque unité de calcul d'envoyer à l'unité de commande centrale des informations sur l'état des cellules associées à son module. Dans le présent exemple, le système de communication 23 comprend un bus de transfert 24 relié au bus de communication 15 via des opto-coupleurs 25. Ces derniers permettent de découpler galvaniquement le module 12 du reste du système. Le nombre d'opto-coupleurs 25 est alors fonction du type de protocole de communication, ainsi un bus SPI de l'exemple décrit comprend 3 fils distincts. Chaque fil du bus comprend donc son opto-coupleur 25. Bien entendu, le protocole de communication n'est pas limité à un bus SPI et l'utilisation de tout autre protocole, tel que par exemple le protocole I²C, est envisageable.

On voit sur la figure 3 que l'unité de calcul 20 est reliée aux quatre blocs électrochimique 3 du groupe 13 via quatre circuits de mesure 22. Dans le présent exemple, les circuits de mesure 22 sont chacun constitués par un amplificateur différentiel 26 associé à un bloc 3, comme représenté à la figure 3. Ces amplificateurs différentiels 26 fonctionnent avec les tensions fournies par l'alimentation 21. Les amplificateurs 26 ont deux entrées respectivement reliées au pôle positif et au pôle négatif des différents blocs 3 comme représenté à la figure 3. Les amplificateurs différentiels 26 sont agencés pour former des montages soustracteurs permettant chacun de mesurer la différence de potentiel entre la cathode et l'anode d'un bloc 3. Dans le présent exemple où chaque groupe 13 comprend quatre blocs 4, il y a donc quatre amplificateurs différentiels 26, soit un par bloc 3.

Comme on l'a déjà dit, conformément à la présente invention, chaque module 12 est rendu indépendant par le fait qu'il possède sa propre référence de tension. Pour cela, la masse de chaque module 12 est reliée à l'une des bornes de connexion de l'un des blocs 3 du groupe 13 qui lui est associé. On comprendra que grâce à cette caractéristique, la différence de potentiel entre les entrées d'un amplificateur différentiel 26 et sa masse ne dépasse pas quelques volts.

De façon préférentielle, le point de connexion servant de référence est pris au milieu de la série de blocs formant le groupe 13. Dans le présent exemple, où les groupes comportent quatre blocs, la tension de référence est donc prise entre le deuxième et le troisième bloc. On comprendra de plus que le nombre maximum de blocs par module dépend de la différence de potentiel maximale tolérée par un amplificateur différentiel 26 entre sa masse et l'une de ses entrées. Ainsi dans le cas où la différence de potentiel maximale tolérée est de 8V et où chaque bloc 3 produit au maximum 1.2V, le nombre maximal de bloc 3 est de 12 (6 X 1.2V. = 7.2V. ; 7.2V. < 8V.).

L'amplificateur différentiel 26 est prévu pour fournir en sortie une tension représentative de la différence de potentiel entre les pôles du bloc 3. L'unité de calcul 20 reçoit sur quatre entrées distinctes les tensions fournies par les quatre amplificateurs différentielles 26 du module 12. Dans le présent exemple, l'unité de calcul 20 est de type numérique et non analogique. Dans ces conditions, les signaux reçus en entrée par l'unité de calcul 20 sont tout d'abord numérisés, et les valeurs numérisées des tensions des différentes cellules 3 sont ensuite envoyées à l'unité de commande centrale 11 via les moyens de communication 23.

L'avantage du principe d'avoir plusieurs amplificateurs 26 par groupe 13 de blocs 3 est d'avoir une rapidité dans la réalisation de la mesure. En effet, il devient alors possible de numériser plusieurs différences de potentiel en même temps. Cette synchronisation des numérisations est améliorée dans le cas où l'unité de calcul 20 comprend un nombre de convertisseurs analogique/numérique égal au nombre d'amplificateurs différentiels 26. Or, étant donné que les blocs 3 sont divisés en groupe 13, chaque groupe 13 effectue les mesures des différences de potentiel en même temps, c'est-à-dire de façon parallèle. Il est donc possible que l'ensemble des mesures de différence de potentiel des blocs 3 soit extraites et numérisées en même temps.

Par contre, dans le cas où l'unité de calcul 20 ne comprend qu'un seul convertisseur analogique/numérique, l'extraction de toutes les différences de potentiel est réalisée en même temps mais la conversion en une valeur numérique des différentes mesures n'est pas réalisée simultanément mais séquentiellement. L'unité de calcul 20 sélectionne alternativement chaque différence de potentiel venant de chaque amplificateur différentiel 26 avec décalage d'environ 20µs. Ainsi, l'intégralité des différences de potentiel 26 d'un groupe 13 de quatre blocs 3 est effectuée en approximativement 80µs. Néanmoins, la division des blocs électrochimique 3 en groupe 13 permet de limiter ces effets. Cela permet théoriquement de réaliser l'intégralité des mesures des différences de potentiel de l'ensemble des blocs 3 en approximativement 80 µs.

Comme on l'a déjà dit, une fois les valeurs des différences de potentiel misent sous forme numériques, ces valeurs sont envoyées vers l'unité de commande 11. Cet envoie de données est réalisé de façon sérielle via le système de communications 23 et le bus de communication 14, c'est-à-dire bloc 3 par bloc 3, les unes à la suite des autres. Ces données sont alors utilisées par l'unité de commande pour gérer la pile à combustible 10.

Un des aspects de la gestion d'une pile à combustible est sa mise à l'arrêt. Pour cela, la pile à combustible 10 comprend des circuits de dérivation afin d'éteindre individuellement chaque bloc 3 en abaissant la différence de potentiel à ses bornes. Cette différence de potentiel est abaissée jusqu'à une valeur proche de zéro et maintenue à cette valeur afin d'éteindre le bloc sans l'endommager. Ces circuits de dérivation peuvent également être employés en cas d'urgence pour isoler un bloc 3 de la pile à combustible 10.

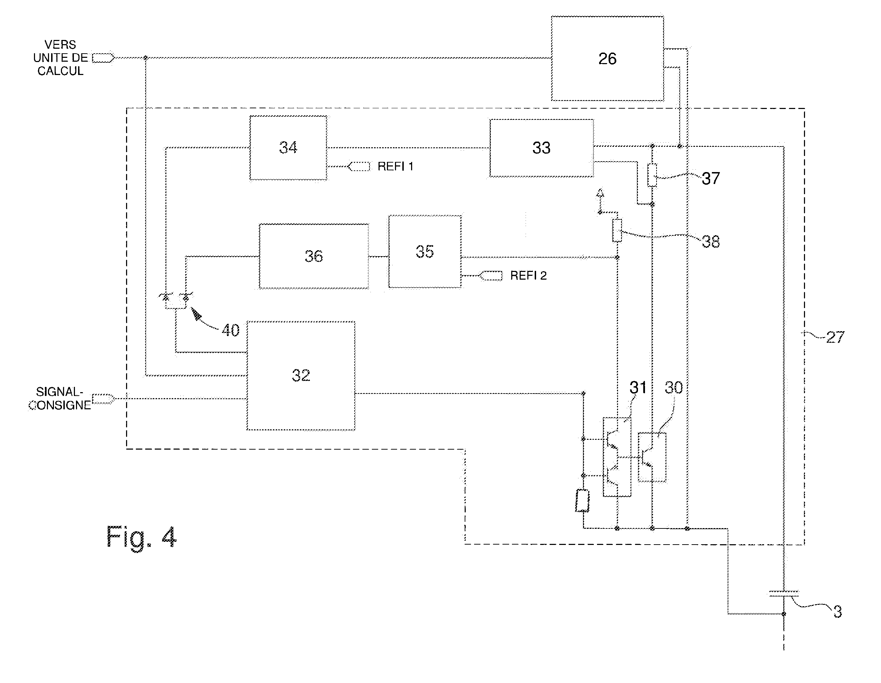

Ces circuits de dérivation sont référencés 27 sur la figure 3, et un mode de réalisation exemplaire de ces circuits de dérivation est représentés schématiquement à la figure 4. En se référant maintenant à la figure 4, on voit que le circuit de dérivation représenté comprend tout d'abord un transistor bipolaire NPN (ou PNP selon la polarisation) référencé 30 qui est connecté entre le pôle positif et le pôle négatif de la cellule 3 en série avec une résistance 37. La base du transistor bipolaire 30 est reliée au point de connexion entre une paire de transistors 31 reliés en série et de polarisation différente. On voit encore sur la figure 4 que les transistors de la paire 31 sont eux-mêmes reliés par leur base à un générateur de contrôle constitué par un sommateur 32 qui comporte une première entrée agencée pour recevoir un signal de consigne venant de l'unité de calcul 20 (figure 3). Le sommateur 32 comporte une deuxième entrée qui est reliée à la sortie à l'amplificateur 26 du circuit de mesure de tension 22. Le sommateur 32 comporte encore une troisième entrée reliée à la fois à la sortie d'un comparateur 34 et à celle d'un inverseur 36. Le circuit comparateur 34 comporte une première entrée qui est reliée à la sortie d'un amplificateur différentiel 33 et une seconde entrée qui est agencée pour recevoir une tension de consigne prédéfinie. L'amplificateur différentiel 33 a deux entrées respectivement reliées aux bornes de la résistance 37 en série avec le transistor bipolaire 30. Outre l'entrée du comparateur 34, la sortie de l'amplificateur différentiel 33 est également reliée à une entrée de l'unité de calcul 20 (figure 3). L'entrée de l'inverseur 36 est reliée à la sortie d'un deuxième comparateur 35. Le comparateur 35 est relié par une première entrée à une des bornes d'une résistance 30 connectée en série avec la paire de transistors 31. L'autre entrée du comparateur 35 est agencée pour recevoir une seconde tension de consigne prédéfinie.

Le circuit de dérivation du présent exemple fonctionne sur le principe de la charge active. La tension appliquée sur la base du transistor NPN 30 permet de faire varier son courant de collecteur. Cette variation du courant et de la tension engendre une variation de l'impédance qui est utilisée dans la présente invention pour contrôler la quantité de courant qui passe dans la dérivation. Le transistor NPN 30 est piloté par l'ensemble formé par la paire de transistors 31 alimentés par une tension +2.5V. Ces deux transistors servent d'intermédiaire entre le transistor NPN servant de charge active et le générateur de contrôle 32. Comme on l'a déjà dit, le générateur de contrôle 32 est un montage à amplificateur différentiel du type sommateur. Ce montage sommateur réalise une somme de trois signaux. Un de ces signaux est la consigne générée par l'unité de calcul 20. Cette consigne peut être un signal du type en modulation de largeur d'impulsions ou du type linéaire.

Le second signal entrant dans le montage sommateur 32 est la mesure de la différence de potentiel du bloc 3 auquel le système à charge active 27 et l'amplificateur différentiel 26 sont connectés. Cette utilisation de la tension mesurée permet de réguler l'extinction du système de contrôle d'une pile de blocs 3 électrochimiques.

Le troisième signal entrant dans le sommateur 32 est un signal de sécurité. En effet, l'utilisation d'un système à charge active pour abaisser la valeur d'une différence de potentiel entraîne une variation du courant. Or, la variation de courant dans un élément résistif entraîne une variation de l'effet joule et donc de la chaleur produite.

Pour cela, le système de dérivation comprend un système limiteur de courant agissant sur le signal de consigne fourni par l'unité de calcul pour limiter le courant traversant la charge active. Ce système limiteur de courant comprend deux modules de surveillance du courant. Un premier module de surveillance est utilisé pour surveiller le courant de dérivation et un second module de surveillance est utilisé pour surveiller le courant traversant la paire de transistors 31 en série pilotant la charge active.

Le premier module comprend la résistance 37 montée en série avec le transistor NPN 30. Cette résistance est utilisée dans un circuit de mesure de courant 33. En effet, le circuit de mesure de courant 33 utilise une résistance externe afin de mesurer le courant dans cette résistance. Cette valeur de courant est ensuite transformée en une valeur de différence de potentiel représentative du courant, qui sera envoyée en sortie. Cette différence de potentiel représentative du courant est alors envoyée vers le circuit comparateur 34 à amplificateur différentiel à fonction intégrateur. Ce circuit comparateur utilise une tension de consigne prédéfinie correspondant au courant à ne pas dépasser. Si la tension représentative du courant est inférieure à cette tension de consigne, le circuit comparateur 34 ne conduit pas et inversement si la tension représentative du courant est supérieure à cette tension de consigne, le circuit comparateur 34 conduit. En cas de conduction, le circuit 34 à fonction intégrateur fait son action. La fonction intégrateur, est alors utilisée pour ralentir le système, c'est-à-dire empêcher de trop fortes variations du signal représentatif du courant servant à corriger le signal de consigne venant de l'unité de calcul. La fonction intégratrice est utilisée pour lisser la tension de correction et par conséquent le signal de consigne.

Le second module est utilisé pour surveiller le courant traversant les deux transistors en série 31 pilotant la charge active. Ce module comprend un montage comparateur 35 à amplificateur différentiel intégrateur. Ce montage comprend une résistance 38 montée en série des deux transistors 31 pilotant le transistor NPN 30 de la charge active, entre l'alimentation 2.5V et le collecteur du premier des deux transistors 31. Aux entrées de l'amplificateur différentiel 35, sont connectées la tension représentative du courant traversant la résistance 38 montée en série avec les deux transistors de commande et la seconde tension de consigne prédéfinie. Si la tension représentative du courant est inférieure à cette tension de consigne, le circuit comparateur ne conduit pas et inversement si la tension représentative du courant est supérieure à cette tension de consigne, le circuit comparateur conduit. En cas de conduction, le signal résultant est alors envoyé dans un montage inverseur 36 afin de permettre la prise en compte de ce signal pour le pilotage de la charge active. Ce second module apporte une protection supplémentaire et n'est donc pas indispensable.

Les signaux sortant des premier et second modules sont ensuite additionnés et envoyés au sommateur 32 pour servir à la régulation. On peut prévoir avantageusement la présence de diodes 40 comme par exemple des diodes schottky en sortie du premier et du second module de surveillance. Ces diodes schottky 40 sont montées en inverse et sont utilisées afin d'empêcher le signal de sortie de chaque module de perturber l'autre module. Ainsi, il n'y a pas de remontée de tension à travers les deux modules.

Dans une première variante, il peut être prévu que des capteurs de température soient installés pour augmenter la protection du système. Ces capteurs de température peuvent se trouver sur la plaque comprenant les divers composants des différents circuits présentés ici mais aussi sur les blocs. En effet, la mesure de la température des blocs 3 voir de chaque cellule permet d'établir des protocoles d'arrêt de la pile à combustible 10. Les capteurs de températures de chaque bloc 3 peuvent être reliés aux unités de calcul associés auxdits blocs 3. Ainsi, comme chaque unité de contrôle gère son propre bloc, il est plus simple que chaque unité de calcul 20 récupère directement les données de température pour agir le plus vite possible. Cette réaction peut être l'arrêt du bloc 3 en question ou bien l'arrêt général du système.

On comprendra que diverses modifications et/ou améliorations et/ou combinaisons évidentes pour l'homme du métier peuvent être apportées aux différents modes de réalisation de l'invention exposée ci-dessus sans sortir du cadre de l'invention défini par les revendications annexées. Par exemple, le système de mesure selon la présente invention peut être appliqué à un système de batterie comprenant une multitude de bloc électrochimique.

## Revendications

1. Système de contrôle d'une pile de blocs (3) électrochimiques ayant chacune deux points de connexion, comprenant :
- un circuit de commande (11) prévu pour envoyer un signal de sélection permettant de sélectionner au moins un bloc électrochimique pour une mesure de différence de potentiel,
- des modules de contrôle (12) agencés pour être respectivement couplés à des groupes (13) distinctes de blocs (3) de la pile et ayant chacun sa propre tension de référence, chaque module de contrôle étant agencé pour, en réponse au signal de sélection envoyé par le circuit de commande, réaliser une mesure de différence de potentiel d'un bloc électrochimique sélectionnée et appartenant au groupe de blocs électrochimique auquel le module de contrôle est associé ;
**Caractérisé en ce que** chaque module de contrôle comprend une pluralité d'amplificateurs différentielles (26) prévus pour être connectés chacun par deux entrées aux deux bornes d'un bloc électrochimique afin de fournir en sortie une tension représentative de la différence de potentiel présente entre les bornes dudit bloc électrochimique.

2. Système selon la revendication 1, **caractérisé en ce que** chaque module de contrôle comprend en outre une unité de calcul (20) à laquelle les amplificateurs différentiels (26) sont reliées et permettant de convertir la différence de potentiel extraite en une valeur numérique.

3. Système selon la revendication 2, **caractérisé en ce que** chaque module de contrôle comprend en outre des moyens de communications (23) reliant l'unité de calcul audit circuit de commande afin d'envoyer la valeur numérique de la différence de potentiel extraite.

4. Système selon la revendication 3, **caractérisé en ce que** les moyens de communication comprennent des moyens d'isolation galvanique (25).

5. Système selon l'une des revendications précédentes, **caractérisé en ce que** ledit au moins un amplificateur différentiel mesure la différence de tension entre les bornes de deux blocs électrochimiques.

6. Système selon l'une des revendications précédentes, **caractérisé en ce que** chaque module de contrôle comprend en outre son propre système l'alimentation (21) afin de pourvoir fonctionner même si le système de contrôle d'une pile de blocs (3) électrochimiques ne fonctionne pas.

7. Système selon l'une des revendications précédentes, **caractérisé en ce que** les amplificateurs différentiels ont une tension maximale d'entrée et **en ce que** dans chaque groupe de blocs électrochimiques, l'addition des différences de potentiel des différents blocs n'excède pas cette tension maximale.

8. Système selon l'une des revendications précédentes, **caractérisé en ce que** chaque groupe de blocs électrochimiques comprend quatre blocs électrochimiques.

9. Système selon la revendication 8, **caractérisé en ce que** chaque bloc électrochimique comprend une cellule à combustible.

10. Système selon la revendication 8, **caractérisé en ce que** chaque bloc électrochimique comprend deux cellules à combustible.

11. Système selon les revendications 1 à 7, **caractérisé en ce que** chaque groupe de cellules électrochimiques comprend huit blocs électrochimiques.

12. Système selon la revendication 11, **caractérisé en ce que** chaque bloc électrochimique comprend une cellule à combustible.
